(19) Europäisches Patentamt
European Patent Office
Office européen des brevets

(11) Veröffentlichungsnummer: **0 238 909**
**B1**

(12) # EUROPÄISCHE PATENTSCHRIFT

(45) Veröffentlichungstag der Patentschrift: **29.08.90**

(51) Int. Cl.⁵: **G01R 33/38**

(21) Anmeldenummer: **87103184.5**

(22) Anmeldetag: **06.03.87**

(54) **Grundfeldmagnet für bildgebende Einrichtungen der Kernspinresonanz-Technik.**

(30) Priorität: **19.03.86 DE 3609226**

(43) Veröffentlichungstag der Anmeldung:
**30.09.87 Patentblatt 87/40**

(45) Bekanntmachung des Hinweises auf die Patenterteilung:
**29.08.90 Patentblatt 90/35**

(84) Benannte Vertragsstaaten:
**DE FR GB**

(56) Entgegenhaltungen:
**EP-A- 0 011 335**
**EP-A- 0 105 565**
**EP-A- 0 144 171**
**EP-A- 0 162 369**
**US-A- 4 385 277**

(73) Patentinhaber: **Siemens Aktiengesellschaft, Wittelsbacherplatz 2, D-8000 München 2(DE)**

(72) Erfinder: **Siebold, Horst, Dr. Dipl.-Phys., Reuthlehenstrasse 63, D-8520 Erlangen(DE)**
Erfinder: **Strahwald, Franz, Pretzfelderstrasse 3, D-8553 Ebermannstadt(DE)**

**EP 0 238 909 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung bezieht sich auf einen Grundfeldmagneten für bildgebende Einrichtungen der Kernspinresonanz-Technik (Kernspin-Tomographie), der mindestens sechs auf einem rohrförmigen Spulenkörper längs einer gemeinsamen Achse hintereinander angeordnete, ringförmiger supraleitender Einzelspulen enthält, mit denen in einem Abbildungsbereich ein magnetisches Grundfeld vorbestimmter erster Feldstärke und hinreichender Homogenität zu erzeugen ist, indem diese Einzelspulen jeweils vorbestimmte elektrische Durchflutungen (Amperewindungszahlen) aufweisen und bezüglich einer durch das Zentrum das Abbildungsbereiches senkrecht zu der Achse verlaufenden Symmetrieebene paarweise symmetrisch und in vorbestimmten mittleren Entfernungen von der Symmetrieebene angeordnet sind, so daß mit zunehmender Entfernung von der Symmetrieebene je ein Paar innerer, mittlerer und äußerer Einzelspulen ausgebildet ist. Ein derartiger Grundfeldmagnet ist aus der US-A 4 385 277, EP-A 162 369 und EP-A 105 565 bekannt.

Auf dem Gebiet der medizinischen Diagnostik sind bildgebende Verfahren entwickelt worden, in denen rechnerisch oder meßtechnisch integrale Resonanzsignale von Kernen eines bestimmten Elementes eines zu untersuchenden, insbesondere menschlichen Körpers oder Körperteiles analysiert werden. Aus der so zu gewinnenden räumlichen Spindichte- und/oder Relaxationszeitver teilung läßt sich dann ein Bild ähnlich einem Röntgentomogramm konstruieren. Entsprechende Verfahren sind unter der Bezeichnung "Kernspin-Tomographie" (Nuclear Magnetic Resonance Tomography) oder "Zeugmatographie" bekannt.

Für die Kernspin-Tomographie ist ein von einem sogenannten Grundfeldmagneten erzeugtes starkes Magnetfeld Voraussetzung, das in einem Abbildungs- bzw. Untersuchungsbereich vorbestimmter Ausdehnung möglichst homogen sein soll und in das der zu untersuchende Körper längs einer Achse, die im allgemeinen mit der Orientierungsachse des magnetischen Grundfeldes übereinstimmt, eingebracht wird. Dieses Grundfeld wird von stationären und/oder gepulsten, sogenannten Gradientenfeldern überlagert. Zur Anregung der einzelnen Atomkerne in dem Körper zu einer Präzessionsbewegung ist außerdem eine besondere Antenneneinrichtung erforderlich, mit der kurzzeitig ein hochfrequentes magnetisches Wechselfeld angeregt werden kann. Vielfach werden auch damit die hervorzurufenden HF-Signale empfangen, falls man hierfür keine besonderen Meßspulen vorsehen möchte.

Der Grundfeldmagnet kann insbesondere sechs in Richtung der Feldorientierung des magnetischen Grundfeldes hintereinandergereihte, ringförmige supraleitende Einzelspulen aufweisen, die gemeinsam auf einem sie gemeinsam tragenden Spulenkörper angeordnet sind. Hierzu ist der aus der eingangs genannten US-A 4 385 277 bekannte Spulenkörper mit entsprechenden Nuten versehen. Diese Nuten sind bezüglich einer durch das Zentrum des Abbildungsbereiches senkrecht zu der Orientierungsachse verlaufenden Symmetrieebene paarweise symmetrisch und in vorbestimmten mittleren Entfernungen von dieser Symmetrieebene angeordnet. In sie werden von außen her die Windungen der Einzelspulen eingebracht. Je nach angestrebter Feldstärke bzw. Induktion des magnetischen Grundfeldes in dem Abbildungsbereich sind dabei die einzelnen Entfernungen der Nuten von der Symmetrieebene, die Anzahl der in sie einzubringenden Leiterwindungen der Einzelspulen sowie der durch die Leiter der Spulen fließende Strom festgelegt. Die entsprechenden einzelnen Parameter werden hierzu in bekannter Weise errechnet (vgl. "Journal of Applied Physics", Vol. 38, No. 6, Mai 1967, Seiten 2563 bis 2586). D.h., für einen Grundfeldmagneten mit einem Spulenkörper vorgegebener Abmessung sind für eine angestrebte Feldstärke des magnetischen Grundfeldes hinreichender Homogenität diese einzelnen Parameter eindeutig festgelegt. Der bekannte Grundfeldmagnet ist außerdem mit einer Reihe von Zusatzspulen ausgestattet. Diese sind nicht mit den sechs Einzelspulen elektrisch zusammengeschaltet, sondern werden davon getrennt erregt. Sie stellen deshalb vom Typ her Shim-Spulen dar.

Für die Kernspin-Tomographie werden supraleitende Grundfeldmagnete gleicher Abmessungen, jedoch für verschiedene Betriebsfeldstärken bzw. magnetische Induktionen von beispielsweise 0,5 T bis 2 T eingesetzt. Da das supraleitende Material der hierfür erforderlichen Einzelspulen sehr teuer ist und eine physikalisch technisch vorgegebene maximale Stromtragfähigkeit besitzt, benötigen unterschiedlich starke Grundfeldmagnete auch unterschiedliche Querschnitte ihrer Wicklungspakete; d.h., diese Einzelmagnete müssen für unterschiedliche elektrische Durchflutungen (Amperewindungszahlen) ausgelegt werden. Da ferner für die Kernspin-Tomographie die magnetischen Grundfelder in dem nutzbaren Abbildungsbereich extrem homogen sein müssen, muß bei Änderung der Betriebsfeldstärke neben den Wickelquerschnitten bzw. den Amperewindungszahlen auch die räumliche Position der Einzelspulen jeweils neu abgeglichen werden. Das führt aber im allgemeinen dazu, daß für Magnete unterschiedlicher Feldstärke auch jeweils ein anderer Spulenkörper mit anderen Abmessungen anzufertigen ist, um den dann die jeweilige vorbestimmte Drahtmenge zu wickeln ist. Die Folge davon ist entweder eine kostenintensive Lagerhalterung oder aber ein langer Durchlaufprozeß von der Bestellung bis zur Lieferung des Magneten.

Aufgabe der vorliegenden Erfindung ist es deshalb, den Spulenkörper der eingangs genannten Art dahingehend auszugestalten, daß mit ihm Grundfeldmagnete für verschiedene Feldstärken mit verhältnismäßig wenig Aufwand zu erstellen sind.

Diese Aufgabe wird erfindungsgemäß mit den im Kennzeichen des Hauptanspruchs angegebenen Maßnahmen gelöst.

Auf dem Spulenkörper des erfindungsgemäßen Grundfeldmagneten wird also die Lage der Einzelspulen exakt für den stärksten Magneten (zur Erzeugung der ersten Feldstärke) festgelegt. Hierbei nutzt man stets die Symmetrie bezüglich der Symmetrieebene aus; bei dem System aus drei Spulenpaaren stehen dann dem Designer drei Windungszahlen und drei Spulenpositionen, also sechs Freiheitsgrade, zur Verfügung, um das vorbestimmte Nutz- bzw. Grundfeld zu erzeugen und die fünf ersten, geraden Terme der bekannten Feldentwicklung nach Kugelfunktionen zu eliminieren. Die ungeraden Terme verschwinden dabei wegen der Symmetrieverhältnisse. Will man nun mit diesem Spulenkörper einen Magneten mit geringerer (zweiter) Feldstärke aufbauen, so bleiben nur zwei Freiheitsgrade zur Elimination der Feldfehler übrig, wenn man die Spulenpositionen von dem stärksten Magneten übernimmt. Dies führt jedoch zu unakzeptablen hohen Feldfehlern. Mit der erfindungsgemäßen Einführung eines Hilfsspulenpaares wird jedoch vorteilhaft wieder ein zusätzlicher Freiheitsgrad gewonnen. Durch die Wahl der besonderen Position dieses Hilfsspulenpaares, deren Mittenradius' sowie durch die an dem inneren Spulenpaar und dem mittleren Spulenpaar erfindungsgemäß vorzunehmenden Korrekturen hinsichtlich ihrer Windungszahlen kann dann der Feldfehler insgesamt so klein gehalten werden, daß eine Verwendung des Spulenkörpers zum Aufbau von Magneten mit geringeren Feldstärken und dennoch hinreichend hoher Homogenität ermöglicht ist. Die Korrekturen werden dabei in Abhängigkeit von der vorgenommenen Wahl der Windungszahl der äußeren Einzelspulen, von deren ursprünglichen Außenradius, von dem Querschnitt des verwendeten Leiters sowie von der Position und dem Mittenradius der Hilfsspulen vorgenommen. Die mit der erfindungsgemäßen Ausgestaltung des Grundfeldmagneten verbundenen Vorteile sind also darin zu sehen, daß sein Spulenkörper für Magnete unterschiedlicher Feldstärken verwendet werden kann. Dabei ist der Bedarf an supraleitendem Material gegenüber der zugrundezulegenden stärksten Version zur Erzeugung der ersten Feldstärke entsprechend zu reduzieren.

Vorteilhafte Ausgestaltungen des erfindungsgemäßen Grundfeldmagneten gehen aus den Unteransprüchen hervor.

Zur weiteren Erläuterung der Erfindung wird auf die Zeichnung Bezug genommen, in deren Figur 1 schematisch ein Längsschnitt durch einen Teil eines erfindungsge mäßen Grundfeldmagneten veranschaulicht ist. Die Figuren 2 und 3 zeigen jeweils in einem Diagramm Korrekturgrößen zur Änderung der Windungszahlen einiger Spulen dieses Magneten.

Bei dem in Figur 1 nur teilweise ausgeführten Grundfeldmagneten wird von bekannten Ausführungsformen einer bildgebenden Einrichtung der Kernspinresonanz-Technik ausgegangen. Der allgemein mit 2 bezeichnete Grundfeldmagnet enthält dabei ein bezüglich der horizontalen z-Achse eines rechtwinkligen x-y-z-Koordinatensystems konzentrisch angeordnetes System von supraleitenden Einzelspulen zur Erzeugung eines magnetischen Grundfeldes in z-Richtung. Dieses Grundfeld ist in einem Abbildungsbereich, in dessen zentraler Mitte M sich der Koordinatenursprung des Koordinatensystems befinden soll, ausreichend homogen. Der Grundfeldmagnet erlaubt einen axialen Zugang zu diesem homogenen Abbildungsbereich; d.h., ein zu untersuchender, beispielsweise menschlicher Körper wird längs der z-Achse in den Feldbereich eingebracht.

Der Grundfeldmagnet 2 umfaßt vorteilhaft sechs längs der z-Achse hintereinandergereihte, ringförmige Einzelspulen. Jeweils zwei dieser Einzelspulen sind bezüglich der durch die x-y-Achse des Koordinatensystems aufgespannten Ebene S symmetrisch angeordnet, so daß sich drei Paare P1, P2 und P4 von Einzelspulen ergeben. In der Figur sind nur die auf der einen Seite dieser Symmetrieebene S, oberhalb der z-Achse liegenden Teile des Grundfeldmagneten näher ausgeführt, so daß das innere, der Symmetrieebene S zugewandte Spulenpaar P1 durch seine Einzelspule 11, das äußerste Spulenpaar P4 nur durch seine Einzelspule 14 und das dazwischenliegende, mittlere Einzelspulenpaar P2 durch seine Einzelspule 12 veranschaulicht sind.

Gemäß der Erfindung ist noch ein weiteres Paar P3 von Hilfsspulen vorgesehen, das in der Nähe der Einzelspulen 14 des äußeren Spulenpaares P4 anzuordnen und in der Figur durch seine Spule 13 veranschaulicht ist. Diese Hilfsspulen 13 werden nicht von einer separaten Stromversorgung gespeist, sondern sind in Serie mit den Einzelspulen 11, 12 und 14 geschaltet und benötigen somit auch keine zusätzlichen Stromzuführungen. Alle Spulen 11 bis 14 der Spulenpaare P1 bis P4, die vorteilhaft aus einem einheitlichen Supraleiter herzustellen sind, werden in entsprechende Nuten 21 bis 24 eines massiven, hohlzylindrischen Spulenkörpers 25 von außen her eingebracht. Die mittleren Entfernungen dieser Nuten 21 bis 24 bzw. der in ihnen angeordneten Spulen 11 bis 14 bezüglich der Symmetrieebene S sind in der Figur auf der z-Achse mit $z_1$ bis $z_4$ eingetragen.

Erfindungsgemäß soll der Spulenkörper 25 so konzipiert sein, daß mit ihm Grundfeldmagnete verschiedener magnetischer Feldstärken bzw. magnetische Induktionen aufzubauen sind. Zur Festlegung der einzelnen Amperewindungszahlen der Spulen der Spulenpaare sowie deren Lagen bezüglich der Symmetrieebene wird hierzu ein Grundfeldmagnet zugrundegelegt, der die größte magnetische Induktion bzw. Feldstärke erzeugen soll. Diese maximale Feldstärke sei nachfolgend als erste Feldstärke bezeichnet. Sie soll in bekannter Weise nur durch die drei Paare P1, P2 und P4 der Einzelspulen 11 bzw. 12 bzw. 14 hervorzurufen sein. Ihre mittleren Entfernungen $z_1$, $z_2$ und $z_4$ bezüglich der Symmetrieebene S sowie ihre elektrischen Durchflutungen bei vorgegebenem Strom lassen sich in bekannter Weise ermitteln (vgl. die genannte Literaturstelle "Journ.Appl. Phys."). Die Werte für die mittleren Entfernungen $z_1$, $z_2$ und $z_4$, für die Windungszahlen $N_1$, $N_2$ und $N_4$ der entsprechenden Einzelspulen sowie für den Querschnitt $q_4$ des Leiters der äußeren Einzelspulen 14 sind also in Abhängigkeit von der ersten Feldstärke vorgegeben. In der Figur ist ein entsprechender Grundfeldmagnet dieser ersten Feldstärke durch seine Einzelspulen angedeutet, deren jeweilige Außenseite 31 bzw. 32 bzw. 34 durch gestrichelte Linien veranschaulicht ist. Der sich ergebende Außenradius der äußersten Einzelspulen 34 sei dabei mit $R_4$ bezeichnet.

Mit demselben Spulenkörper 25 ist nun erfindungsgemäß ein Grundfeldmagnet 2 für eine gegenüber der ersten Feldstärke geringere zweite Feldstärke aufzubauen, wobei in die gleichen Nuten 21, 22 und 24 die Einzelspulen 11, 12 und 14 mit geringeren Windungszahlen $N_1'$, $N_2'$ und $N_4'$ einzuwickeln sind. Die mittleren Entfernungen $z_1$, $z_2$ und $z_4$ der Einzelspulen 11, 12 und 14 von der Symmetrieebene S sowie ihre Innenradien sind somit unverändert. Da außerdem die Stromtragfähigkeit des supraleitenden Leiters, aus dem diese Einzelspulen zu wickeln sind, von seinem Querschnitt und von seiner technischen Ausführung (Verhältnis Supraleiter- zu Stabilisierunsmaterial, Herstellungstechnologie) abhängt, kann für die niedrigere (zweite) Betriebsfeldstärke außerdem ein anderer Leiterquerschnitt $q_4'$ für die äußeren Einzelspulen 14 gewählt werden.

Zum Aufbau des Magneten 2 mit verringerter Feldstärke wird nun zunächst eine geringere Windungszahl $N_4'$ in der Nut 24 für die äußeren Einzelspulen 14 des Spulenpaares P4 vorgesehen. Das somit vorzugebende Verhältnis $N_4'/N_4$ sei mit $\alpha$ bezeichnet. Wählt man außerdem einen abweichenden Leiterquerschnitt $q_4'$, so reduziert sich die radiale Höhe des Wickelpaketes der äußeren Einzelspulen 14 auf den Faktor

$\beta = N_4' . q_4' / (N_4 . q_4) = \alpha . q_4'/q_4$.

Statt des ursprünglichen Außenradius $R_4$ der Einzelspulen 34 ist dann ein entsprechend reduzierter $R_4'$ anzunehmen. Gemäß dem dargestellten Ausführungsbeispiel ist $\beta$ ungefähr 0,5. Verwendet man jedoch vorteilhaft den gleichen Leiter wie für die Hochfeldversion (erste Betriebsfeldstärke), so ist folglich $\alpha = \beta$.

Darüber hinaus ist für die Version des Grundfeldmagneten 2 mit verringerter Feldstärke das HilfsspulenPaar P3 vorzusehen, um die mit der Beibehaltung der Positionen $z_1$, $z_2$ und $z_4$ für die Einzelspulenpaare P1, P2 und P4 verbundenen Feldfehler korrigieren zu können.

Die Nut 23 zur Aufnahme der entsprechenden Hilfsspulen 13 wird dabei vorteilhaft in der Nähe der Nut 24 ausgebildet, wobei Gesichtspunkte einer mechanisch hinreichend festen Abstützung der einzelnen Windungen innerhalb der Nuten zu berücksichtigen sind. Die Trennwände 26 zwischen den Nuten 23 und 24 müssen also, in axialer Richtung gesehen, so weit ausgedehnt sein, daß eine unverrückbare Lage der Einzelspulen 14 gewährleistet ist. Dennoch besteht eine gewisse Freiheit bei der Wahl der Mittenposition $z_3$ der Hilfsspulen 13 und ihres Mittenradius' $R_3$. Hiermit lassen sich auch individuelle konstruktive Gestaltungswünsche bzgl. des Spulenkörpers berücksichtigen. Besonders vorteilhaft ist es, wenn man für die Wahl der Entfernung $z_3$ und/oder des Radius' $R_3$ die folgenden Beziehungen zumindest annähernd zugrundelegt:

$z_3 / z_4 = 0{,}831$,

$R_3 / R_4 = 1{,}0$.

Neben den Entfernungen $z_1$ bis $z_4$ sind also auch die Größen $N_1$ bis $N_4$, $R_3$, $R_4$ und $N_4'$ sowie $q_4$ und $q_4'$ vorgegeben. Um nun, ausgehend von diesen Größen, die Windungszahl $N_3'$ der Hilfsspulen 13 des Spulenpaares P3 zu bestimmen, wird auf das Diagramm der Figur 2 Bezug genommen. In diesem Diagramm sind auf der Abszisse der Reduktionsfaktor $\beta = (N_4'/N_4) \cdot (q_4'/q_4) = \alpha \cdot (q_4'/q_4)$ und auf der Ordinate das Verhältnis $N_3'/N_4'$ aufgetragen. Das Diagramm zeigt zwei Kurven für unterschiedliche Verhältnisse von $z_3 / z_4$. Anhand dieser Kurven ergibt sich für die Windungszahl $N_3'$ die folgende, auch für geänderte Leiterquerschnitt $q_4'$ allgemein gültige Beziehung:

$N_3'/N_4' = H_1 \cdot K_1 \cdot K_2$,

wobei gilt: $H_1 = (1-\beta) \cdot 0{,}066$,

$K_1 = 1 + (z_3/z_4 - 0{,}831) \cdot 9{,}08$ und

$K_2 = R_3/R_4$.

Mit dem Glied $H_1$ wird dabei der Haupteffekt der Korrektur beschrieben, während $K_1$ und $K_2$ eine erste bzw. zweite Feinkorrektur bewirken. Die zweite Feinkorrektur ergibt sich aus dem Absenken der notwendigen elektrischen Durchflutung bzw. Windungszahl $N_3'$ bei kleinerem Hilfsspulenradius $R_3$.

Außerdem muß entsprechend den in dem Diagramm der Figur 3 gezeigten Kurven die Bewicklung der Einzelspulen 11 des innersten Spulenpaares $P_1$ etwas größer gewählt werden, als es dem Reduktionsfaktor $\alpha$ bzw. $\beta$ bei den äußeren Einzelspulen 14 entspricht. In diesem Diagramm sind entsprechend Figur 2 die sich für zwei verschiedene Werte von $z_3 / z_4$ ergebenden Kurven $(N_1'/N_1)-\alpha$ eingetragen, wobei hier $\alpha = \beta$ gewählt ist. Die quadratische Abhängigkeit dieser Kurven von $\alpha$ ist plausibel. In grober Näherung können nämlich die Windungen $N_3'$ der Hilfsspulen 13 den benachbarten Windungen der äußeren Einzelspulen 14 hinzugerechnet werden, so daß dann jeweils die Summe der Windungszah len $N_3' + N_4'$ im Vergleich zu der Bewicklung der inneren Einzelspulen 11 zu betrachten ist. Eine genaue Rechnung mit dem in dem Diagramm der Figur 3 gezeigten Verlauf der beiden Kurven führt zu der folgenden Beziehung:

$(N_1'/N_1) - \alpha = H_2 \cdot K_3 \cdot K_4$

mit $H_2 = \alpha \cdot (1 - \beta) \cdot 0{,}104$

$K_3 = 1 + (z_3 / z_4 - 0{,}831) \cdot 5{,}92$ und

$K_4 = K_2$.

$H_2$ stellt dabei das Hauptkorrekturglied dieser Beziehung dar, während $K_3$ einen ersten Korrekturfaktor und $K_4$ einen zweiten Korrekturfaktor bedeuten.

Für die Windungszahlen $N_2'$ der Spulen 12 des mittleren Spulenpaares P2 ergeben sich identische Korrekturregeln wie zur Festlegung von $N_1'$.

Unter Zugrundelegung der vorstehend aufgeführten Beziehungen zur Festlegung der Windungszahlen $N_1'$, $N_2'$ und $N_3'$ wird dann ein für die Kernspintomographie hinreichend homogenes Magnetfeld in dem Abbildungsbereich mit einem akzeptablen Restfehler 8. Ordnung erhalten. Im allgemeinen sind die Anforderungen an die Feldhomogenität bei geringeren Feldstärken auch nicht so extrem hoch. Bei diesen Feldstärken ist nämlich im allgemeinen nur noch Bildgebung mittels der Kernspinresonanz von Protonen möglich, nicht aber eine Spektroskopie anderer Kerne wie z.B. Phosphor.

Bei dem den Figuren zugrundegelegten Ausführungsbeispiel wurde davon ausgegangen, daß die

äußeren Einzelspulen 14 aus dem gleichen Supraleiter gewickelt werden, wie er auch für die Hochfeldauslegung (erste Feldstärke) zugrundegelegt wurde, d.h., daß $q_4' = q_4$ gilt.

Dies ist im allgemeinen vorzuziehen. Jedoch kann man gegebenenfalls auch einen geringeren Querschnitt $q_4'$ wählen, falls z.B. ein ähnlicher oder auch gleicher Betriebsstrom bei einer höheren mittleren effektiven Stromdichte gewünscht wird. Dabei wird die aufzufangende Störung durch die Reduzierung der geometrischen radialen Dicke bzw. des Außenradius' der Einzelspulen des äußeren Spulenpaares P4 verursacht, wobei gilt

$$\beta = \frac{\Delta R_4'}{\Delta R_4}$$

Bei ähnlicher Wicklungstechnik kann dies ereicht werden durch eine Reduzierung der Windungszahl N und/oder durch eine Reduzierung des Leiterquerschnittes q, d.h., es gilt folglich:

$\beta = (N_4'/N_4) \cdot (q_4'/q_4) = \alpha \cdot (q_4'/q_4)$
mit $\alpha = N_4'/N_4$.

Gemäß dem dargestellten Ausführungsbeispiel wurde ferner angenommen, daß der Spulenkörper 25 aus einem einzigen Stück besteht, wobei die Nuten 21 bis 24 in seine Außenseite eingearbeitet sind. Gegebenenfalls läßt sich jedoch auch ein entsprechender mehrteiliger Spulenkörper verwenden. So können beispielsweise die Nuten auch zwischen ringförmigen Stegen ausgebildet sein, die auf der Außenseite eines ringförmigen Trägerkörpers angeordnet sind.

**Patentansprüche**

1. Grundfeldmagnet für bildgebende Einrichtungen der Kernspinresonanz-Technik z.B. Kernspin-Tomographie, der mindestens sechs auf einem rohrförmigen Spulenkörper längs einer gemeinsamen Achse hintereinander angeordnete, ringförmige supraleitende Einzelspulen enthält, mit denen in einem Abbildungsbereich ein magnetisches Grundfeld vorbestimmter erster Feldstärke und hinreichender Homogenität zu erzeugen ist, indem diese Einzelspulen jeweils vorbestimmte elektrische Durchflutungen, d.h. Amperewindungszahlen, aufweisen und bezüglich einer durch das Zentrum des Abbildungsbereiches senkrecht zu der Achse verlaufenden Symmetrieebene paarweise symmetrisch und in vorbestimmten mittleren Entfernungen von der Symmetrieebene angeordnet sind, so daß mit zunehmender Entfernung von der Symmetrieebene je ein Paar innerer, mittlerer und äußerer Einzelspulen ausgebildet ist, **dadurch gekennzeichnet**, daß zur Erzeugung einer gegenüber der ersten Feldstärke geringeren zweiten Feldstärke hinreichender Homogenität bei vorgegebenem Strom
- auf den Spulenkörper (25) die Einzelspulen (11, 12, 14) der Spulenpaare (P1, P2, P4) unter den gleichen mittleren Entfernungen ($z_1$, $z_2$, $z_4$) bezüglich der Symmetrieebene S, jedoch mit reduzierten Windungszahlen ($N_1'$, $N_2'$, $N_4'$) aufgebracht sind,
- zusätzlich ein Paar (P3) von Hilfsspulen (13) vorgesehen ist, die jeweils in Reihe mit den Einzelspulen (11, 12, 14) geschaltet und zwischen den mittleren und äußeren Einzelspulen (12 bzw. 14) in der Nähe der äußeren Einzelspulen (14) auf dem Spulenkörper (25) angeordnet sind
und
- für die reduzierten Windungszahlen $N_3'$, $N_2'$ und $N_1'$ der Hilfsspulen (13) bzw. mittleren Einzelspulen (12) bzw. inneren Einzelspulen (11) die folgenden Beziehungen gelten:

a) $N_3'/N_4' = 0{,}066 \cdot (1-\beta) \cdot \cdot [1 + 9{,}08\ (z_3/z_4 - 0{,}831)] \cdot (R_3/R_4)$,

b) $N_2'/N_2 - \alpha = N_1'/N_1 - \alpha = 0{,}104 \cdot \alpha \cdot (1-\beta) \cdot \cdot [1 + 5{,}92\ (z_3/z_4 - 0{,}831)] \cdot (R_3/R_4)$,

mit

c) $\beta = (N_4'/N_4) \cdot (q_4'/q_4) = \alpha\ (q_4'/q_4)$,

wobei

$q_4$ und $q_4'$ der für die erste bzw. zweite Feldstärke gewählte Querschnitt der Leiter der äußeren Einzelspulen (34 bzw. 14),

$z_3$ und $R_3$ die vorzugebende mittlere Entfernung jeder Hilfsspule (13) von der Symmetrieebene S bzw. deren vorzugebender Mittenradius,

$z_4$ die mittlere Entfernung jeder äußeren Einzelspule (14) von der Symmetrieebene S,

$R_4$ der ursprüngliche Außenradius der für die erste Feldstärke vorgegebenen äußeren Einzelspulen (34),

$N_4'$ die für die zweite Feldstärke vorzugebende Windungzahl der äußeren Einzelspulen (14)

sowie

$N_1$, $N_2$ und $N_4$ die sich für die erste Feldstärke ergebenden Windungszahlen der inneren Einzelspulen (31) der mittleren Einzelspulen (32) bzw. der äußeren Einzelspulen (34) sind.

2. Grundfeldmagnet nach Anspruch 1, **dadurch gekennzeichnet**, daß seine Einzelspulen (11, 12, 14) und seine Hilfsspulen (13) in Nuten (21,22, 24 bzw. 23) angeordnet sind.

3. Grundfeldmagnet nach Anspruch 1 oder 2, **dadurch gekennzeichnet,** daß die mittlere Entfernung ($z_3$) der Hilfsspulen (13) zumindest annähernd das 0,831-Fache der mittleren Entfernung ($z_4$) der äußeren Einzelspulen (14) beträgt.

4. Grundfeldmagnet nach einem der Ansprüche 1 bis 3, **dadurch gekennzeichnet**, daß der Mittenradius ($R_3$ ) der Hilfsspulen (13) zumindest annähernd gleich dem sich für die erste Feldstärke ergebenden, ursprünglichen Außenradius ($R_4$) der äußeren Einzelspulen (34) gewählt ist.

5. Grundfeldmagnet nach einem der Ansprüche 1 bis 4, **dadurch gekennzeichnet**, daß seine Einzelspulen (11, 12, 14) und seine Hilfsspulen (13) aus einem einheitlichen Supraleiter gewickelt sind.

6. Grundfeldmagnet nach Anspruch 5, **dadurch gekennzeichnet**, daß seine Einzelspulen (11, 12, 14) und seine Hilfsspulen (13) aus dem für die erste Feldstärke zugrundegelegten Supraleiter gewickelt sind.

## Revendications

1. Aimant de champs magnétique de base pour des installations de formation d'images de la technique de la résonance magnétique nucléaire, par exemple la tomographie à spin nucléaire, qui comporte au moins six bobines individuelles supraconductrices de forme annulaire et disposées sur un corps de bobine de forme tubulaire, l'une derrière l'autre le long d'un axe commun, avec lesquelles doit être produit, dans une zone d'image, un champs magnétique de base d'une première intensité de champs prédéterminée et d'un homogénéité suffisante, en faisant en sorte que ces bobines individuelles présentent respectivement des nombres d'ampèretours prédéterminés et sont disposées, par rapport à un plan de symétrie passant par le centre de la zone d'image et perpendiculaire à l'axe, symétriquement par paires et à des distances moyennes du plan de symétrie, l'agencement étant tel, que sont formées, pour une distance croissante par rapport au plan de symétrie, respectivement une paire intérieure, médiane et extérieure de bobines individuelles, caractérisé par le fait que pour produire, pour un courant prédéterminé, une seconde intensité de champs plus faible par rapport à la première intensité de champs, et d'homogénéité suffisante,
– on dispose sur le corps de bobine (25) les bobines individuelles (11, 12, 14) des paires de bobines (P1, P2, P4) aux mêmes distances moyennes par rapport au plan de symétrie S, mais avec des nombres de spires réduits ($N_1'$, $N_2'$, $N_4'$)
– on prévoit, en plus, une paire ($P_3$) de bobines auxiliaires (13) reliées respectivement en série avec les bobines individuelles (11, 12, 14) et disposées entre les bobines individuelles médianes et extérieures (12, 14), dans le voisinage des bobines individuelles extérieures (14), sur le corps de bobine (25), et
– les relations suivantes étant valables pour les nombres de spires réduits $N_3'$, $N_2'$ et $N_1'$ des bobines auxiliaires (13), des bobines individuelles médianes (12) et des bobines individuelles intérieures (11) respectivement:

a) $N_3'/N_4' = 0{,}066 \cdot (1-\beta) \cdot [1 + 9{,}08\,(z_3/z_4 - 0{,}831)] \cdot (R_3/R_4)$,

b) $N_2'/N_2 - \alpha = N_1'/N_1 - \alpha = 0{,}104 \cdot \alpha \cdot (1-\beta) \cdot [1 + 5{,}92\,(z_3/z_4 - 0{,}831)] \cdot (R_3/R_4)$,

avec

c) $\beta = (N_4'/N_4) \cdot (q_4'/q_4) = \alpha \cdot (q_4'/q_4)$,

$q_4$ et $q_4'$ désignant la section transversale choisie pour les conducteurs des bobines individuelles extérieures (34 et 14) pour la première et la seconde intensité de champs respectivement,

$z_3$ et $R_3$ désignant la distance médiane moyenne à prévoir entre chaque bobine auxiliaire (13) et le plan de symétrie S et son rayon moyen, à fixer à l'avance,

$z_4$ désignant la distance moyenne entre chaque bobine individuelle extérieure (14) et le plan de symétrie S,

$R_4$ désignant le rayon extérieur originel des bobines individuelles extérieures (34), fixées à l'avance pour la première intensité de champs

$N_4'$ désignant le nombre de spires, à fixer à l'avance, des bobines individuelles extérieures (14) pour la seconde intensité de champs,

$N_1$, $N_2$ et $N_4$ désignant le nombre de spires des bobines individuelles intérieures (31), des bobines individuelles médianes (32) et des bobines individuelles extérieures (34) respectivement, qui en résultent pour la première intensité de champs.

2. Aimant de champs de base selon la revendication 1, caractérisé par le fait que ses bobines individuelles (11, 12, 14) et ses bobines auxiliaires (13), sont disposées dans des gorges (21, 22, 24 et 23).

3. Aimant de champs de base selon la revendication 1 ou 2, caractérisé par le fait que la distance moyenne ($z_3$) des bobines auxiliaires (13) est au moins approximativement égale à 0,831 fois la dimension moyenne ($z_4$) des bobines individuelles extérieures (14).

4. Aimant de champs de base selon l'une des revendications 1 à 3, caractérisé par le fait que le rayon médian ($R_3$) des bobines auxiliaires (13) est choisi pour être au moins approximativement égal au rayon extérieur originel ($R_4$) des bobines individuelles extérieures (34), qui en résulte pour la première intensité de champs.

5. Aimant de champs de base selon l'une des revendications 1 à 4, caractérisé par le fait que ses bobines individuelles (11, 12, 14) et ses bobines auxiliaires (13), sont bobinées avec un supraconducteur uniforme.

6. Aimant de champs de base selon la revendication 5, caractérisé par le fait que ses bobines individuelles (11, 12, 14) et ses bobines auxiliaires (13), sont bobinées avec le supraconducteur qui a été adopté pour la première intensité de champs.

## Claims

1. Main-field magnet for imaging devices of the nuclear-magnetic resonance technique, for example nuclear-magnetic tomography, which main-field magnet comprises at least six annular, superconducting individual coils which are arranged consecutively on a tubular coil body along a common axis, by means of which individual coils a magnetic mainfield of predetermined first field strength and adequate homogeneity can be produced in a imaging region, by virtue of the fact that the said individual coils have in each case pre-determined numbers of ampere turns and are arranged, with respect to a plane of symmetry extending through the centre of the imaging region and perpendicularly to the axis, symmetrically in pairs and at pre-determined average distances from the plane of symmetry, so that, with increasing distance from the plane of symmetry, one pair each of inner, middle and outer individual coils is formed, characterised in that, in order to produce a second field strength which is less than the first field strength and is of adequate homogeneity with a pre-selected current:
– the individual coils (11, 12, 14) of the coil pairs (P1, P2, P4) are applied to the coil body (25) with the same average distances ($z_1$, $z_2$, $z_4$) with respect to the plane of symmetry S, though with reduced numbers of turns ($N_1'$, $N_2'$, $N_4'$);
– additionally, a pair (P3) of auxiliary coils (13) is provided which are in each case connected in series to

the individual coils (11, 12, 14) and are arranged on the coil body (25) between the middle and outer individual coils (12 and 14 respectively) near the outer individual coils (14);

– and for the reduced numbers of turns $N_3'$, $N_2'$, and $N_1'$ of the auxiliary coils (13), middle individual coils (12) and inner individual coils (11) respectively, the following relationships are true:

a) $N_3'/N_4' = 0{,}066 \cdot (1-\beta) \cdot [1 + 9{,}08\ (z_3/z_4 - 0{,}831)] \cdot (R_3/R_4)$,

b) $N_2'/N_2 - \alpha = N_1'/N_1 - \alpha = 0{,}104 \cdot \alpha \cdot (1 - \beta) \cdot [1 + 5{,}92\ (z_3/z_4 - 0{,}831)] \cdot (R_3/R_4)$,

with

c) $\beta = (N_4'/N_4) \cdot (q_4'/q_4) = \alpha \cdot (q_4'/q_4)$,

$q_4$ and $q_4'$, being the cross-sections, chosen for the first and second field strengths respectively, of the conductors of the outer individual coils (34 and 14 respectively), $z_3$ and $R_3$ being the specifiable average distance of each auxiliary coil (13) from the plane of symmetry S, and the specifiable mean radius thereof respectively,

$z_4$ being the average distance of each outer individual coil (14) from the plane of symmetry S,

$R_4$ being the original outer radius of the outer individual coils (34) specified for the first field strength,

$N_4'$ being the number of turns, specifiable for the second field strength, of the outer individual coils (14),

and $N_1$, $N_2$ and $N_4$ being the numbers of turns, resulting for the first field strength, of the inner individual coils (31), the middle individual coils (32) and the outer individual coils (34) respectively.

2. Main-field magnet according to claim 1, characterised in that the individual coils (11, 12, 14) and auxiliary coils (13) thereof are arranged in slots (21, 22, 24 and 23 respectively).

3. Main-field magnet according to claim 1 or 2, characterised in that the average distance ($z_3$) of the auxiliary coils (13) amounts to at least approximately the 0.831-multiple of the average distance ($z_4$) of the outer individual coils (14).

4. Main-field magnet according to one of claims 1 to 3, characterised in that the mean radius ($R_3$) of the auxiliary coils (13) is chosen to be at least approximately the same as the original outer radius ($R_4$), resulting for the first field strength, of the outer individual coils (34).

5. Main-field magnet according to one of claims 1 to 4, characterised in that the individual coils (11, 12, 14) and auxiliary coils (13) thereof are wound from a uniform superconductor.

6. Main-field magnet according to claim 5, characterised in that the individual coils (11, 12, 14) and auxiliary coils (13) thereof are wound from the superconductor which is the basis for the first field strength.

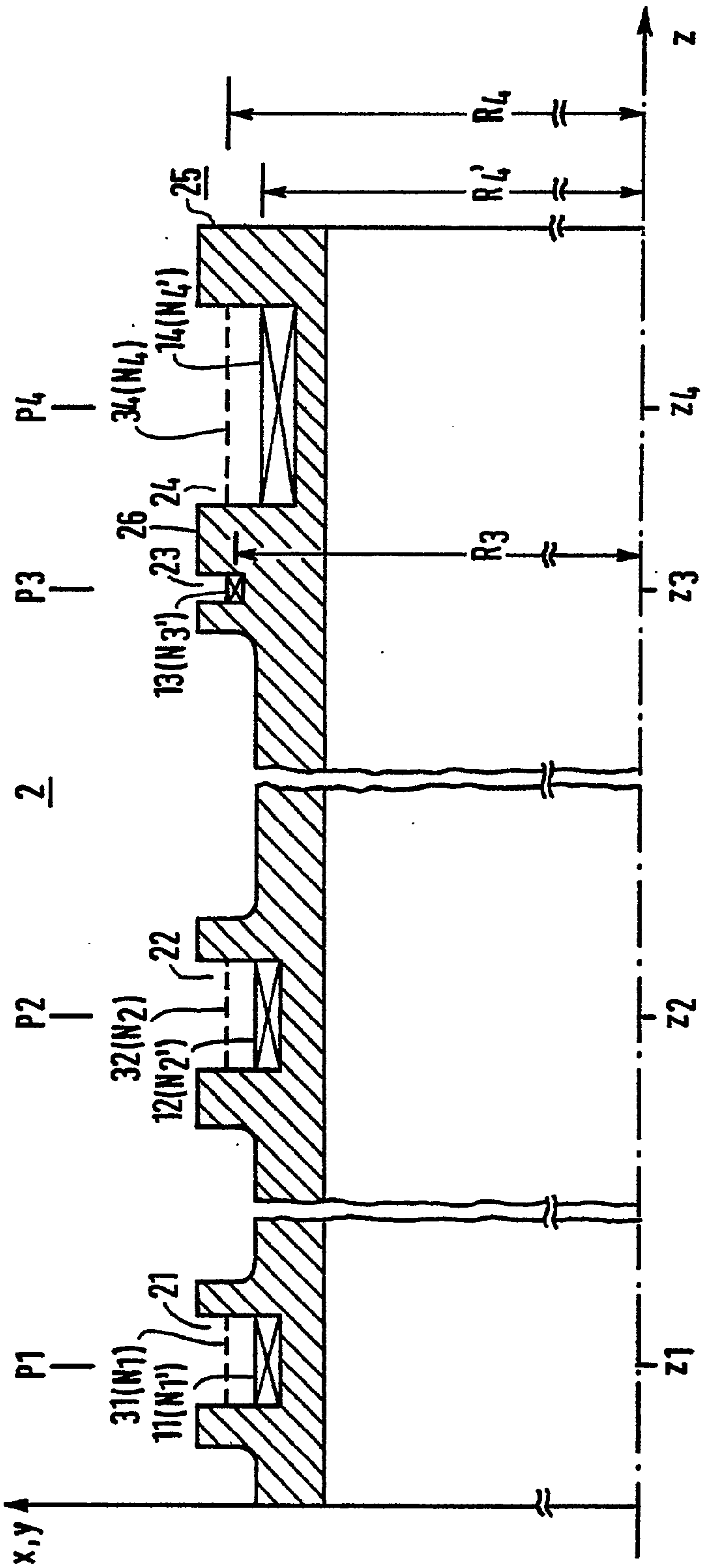
x,y
z
P1
P2
P3
P4
2
11(N1')
31(N1)
21
12(N2')
32(N2)
22
13(N3')
23
26
24
34(N4)
14(N4')
25
R3
R4'
R4
z1
z2
z3
z4

FIG 1

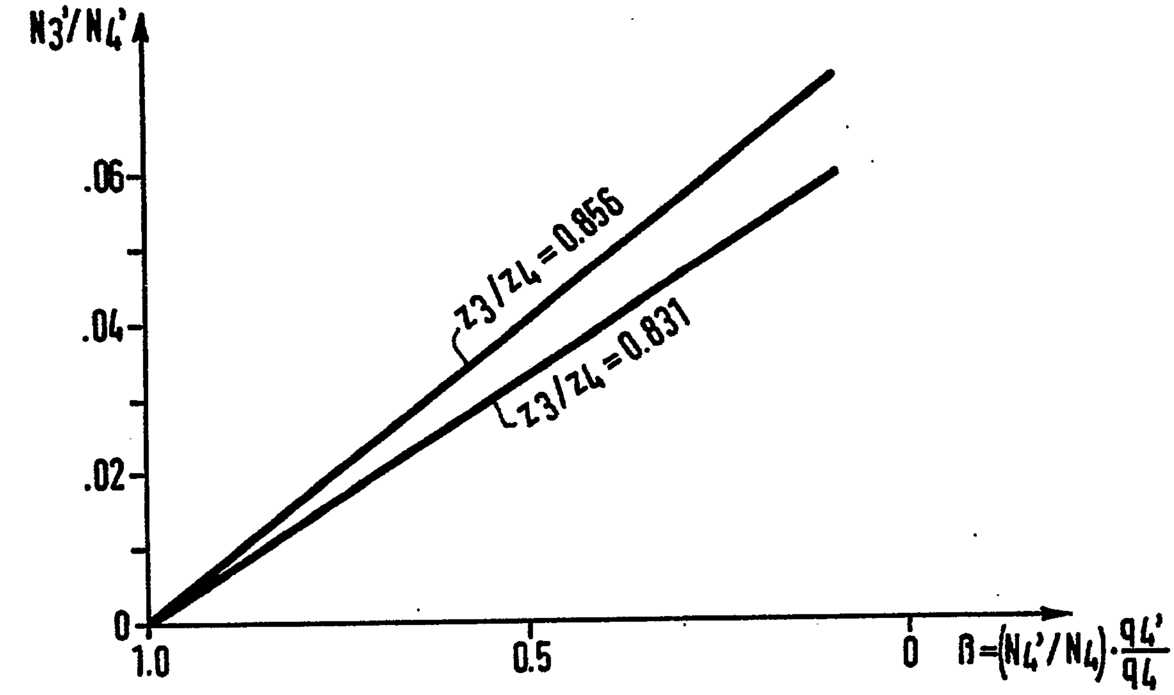
N3'/N4'
.06
.04
.02
0
1.0
0.5
0
z3/z4=0.856
z3/z4=0.831
B=(N4'/N4)·q4'/q4

FIG 2

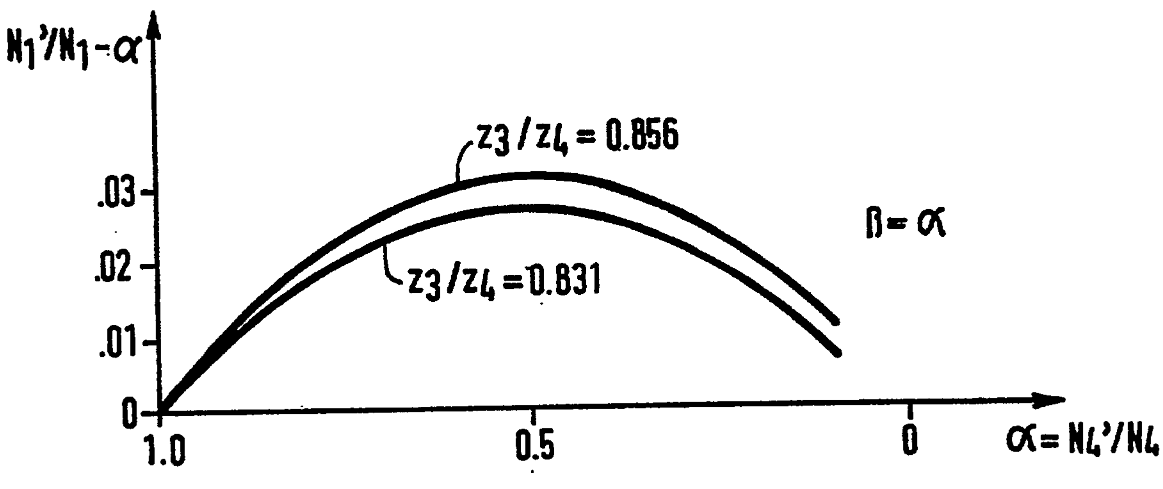
N1'/N1-α
.03
.02
.01
0
1.0
0.5
0
z3/z4=0.856
z3/z4=0.831
B=α
α=N4'/N4

FIG 3